(19) Europäisches Patentamt
European Patent Office
Office européen des brevets

(11) Veröffentlichungsnummer: **0 045 366 B1**

(12) **EUROPÄISCHE PATENTSCHRIFT**

(45) Veröffentlichungstag der Patentschrift: **30.05.84**

(51) Int. Cl.³: **C 08 L 65/02**, H 01 B 1/12, H 01 L 31/02

(21) Anmeldenummer: **81104594.7**

(22) Anmeldetag: **15.06.81**

# (54) Verfahren zur Herstellung elektrisch leitfähiger löslicher Heteropolyphenylene und deren Verwendung.

(30) Priorität: **08.07.80 DE 3025771**

(43) Veröffentlichungstag der Anmeldung: **10.02.82 Patentblatt 82/6**

(45) Bekanntmachung des Hinweises auf die Patenterteilung: **30.05.84 Patentblatt 84/22**

(84) Benannte Vertragsstaaten: **BE DE FR GB NL**

(56) Entgegenhaltungen:
**EP - A - 0 016 305**
**EP - A - 0 023 595**
**EP - A - 0 023 596**
**CH - A - 444 314**

(73) Patentinhaber: **BASF Aktiengesellschaft, Carl-Bosch-Strasse 38, D-6700 Ludwigshafen (DE)**

(72) Erfinder: **Naarmann, Herbert, Dr., Haardtblick 15, D-6719 Wattenheim (DE)**
Erfinder: **Naegele, Dieter, Dr., Obere Jakobstrasse 8, D-6520 Worms (DE)**
Erfinder: **Penzien, Klaus, Dr., Bensheimer Ring 18, D-6710 Frankenthal (DE)**
Erfinder: **Schlag, Johannes, Dr., Leuschnerstrasse 36, D-6700 Ludwigshafen (DE)**

**EP 0 045 366 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein Verfahren zur Herstellung von elektrisch leitfähigen löslichen Heteropolyphenylenen mit elektrischen Leitfähigkeitswerten grösser als $10^{-2}$S/cm und deren Verwendung in der Elektrotechnik zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bekannt, Polyphenylene durch oxidative Kupplung entsprechend der Literatur: «Macromolecular Syntheses Collective», Vol. 1, (1979) Seiten 109 bis 110, Verlag John Wiley & Sons, und «Naturwissenschaften» 56 (1969), Seiten 308 bis 313, herzustellen. Ausserdem ist die Herstellung von Polyphenylenen durch stufenweise Polykondensation nach R. Gehm und W. Kern in «Makromolekulare Chemie» 7 (1951), Seiten 46–61, beschrieben, wobei besonders einheitliche, paraverkettete methylsubstituierte Derivate erhalten werden, die nicht zusätzlich durch ortho- oder meta-verknüpfte Polymere verunreinigt sind.

Aus den EP-A1-0 023 595, EP-A1-0 023 596 und EP-A1-0 016 305 war es bekannt, Polyphenylenen Lewis-Säuren bzw. Alkalimetalle oder deren Amide zuzusetzen, um Polymere mit einer verbesserten elektrischen Leitfähigkeit zu erhalten.

Durch die Arbeiten von J.K. Stille, «Makromolekulare Chemie», 154, 49 (1972) wurde die Möglichkeit bekannt, durch Diels-Alder-Kondensation Heteropolyphenylene zu erhalten.

Der Erfindung lag die Aufgabe zugrunde, lösliche Heteropolyphenylene herzustellen und durch aktivierende Zusätze in elektrisch leitfähige Polymere mit elektrischen Leitfähigkeitswerten grösser als $10^{-2}$ S/cm umzuwandeln.

Diese Aufgabe wird erfindungsgemäss dadurch gelöst, dass man Heteropolyphenylenen der allgemeinen Formel (I):

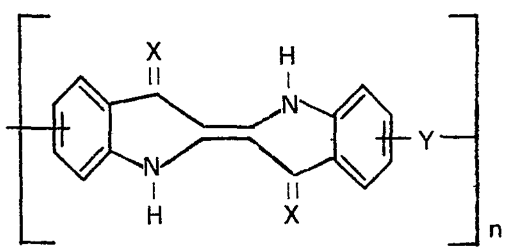

I

in der X gleich O, S, Se, SO oder $SO_2$ und Y gleich X oder NH, $CH_2$, CO oder $C_6H_4$ sein kann und n = 2 bis 250, vorzugsweise 5 bis 50, unter Ausschluss von Wasserfeuchtigkeit und von Sauerstoff 0,5 bis 5 Gewichtsprozent, bezogen auf das eingesetzte Heteropolyphenylen, einer starken Lewis-Säure mit $pK_S$-Werten von 10 bis 14 oder Natrium, Kalium, Rubidium, Cäsium, Calcium oder Barium oder deren Amide als aktivierender Zusatzstoff zusetzt.

Nach einer bevorzugten Verfahrensweise wird als Lewis-Säure die Verbindung $AsF_5$, $SbF_5$, $UF_6$, $HClO_4$, $NO^+SbF_6^-$, $NO_2^+SbF_6^-$, $NO^+AsF_6^-$, $NO^+PF_6^-$, $SbCl_5$, $NO^+BF_4^-$, $(CF_3)_2SO_4$, 2,4,6-Trinitrophenol, 2,4,6-Trinitrophenylsulfonsäure verwendet. Bevorzugt ist auch ein Verfahren, bei dem Alkali- oder Erdalkalimetalle mit Hilfsflüssigkeiten wie Tetrahydrofuran, Dimethoxyglykol, Anthracen, Naphthalin oder 2-Methylstyrol, jeweils im Molverhältnis 1:1 bis 1:5, vorzugsweise 1:2 bis 1:3, verwendet werden.

Zur Herstellung der Heteropolyphenylene (I) geht man von difunktionellen Phenylglycinen aus, z.B. von der Diaminoisophthalsäure (II). Diese Verbindungen werden analog der klassischen Indigosynthese umgesetzt.

(Vgl. H.R. Christen Lehrbuch der organ. Chemie S. 710 (1970) Sauerländer Verlag Aarau).

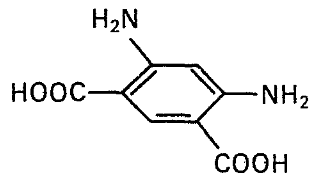

II,

In den löslichen Heteropolyphenylenen der allgemeinen Formel (I) ist

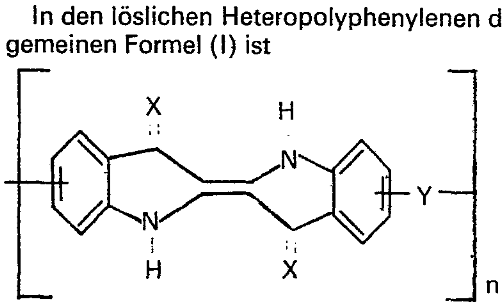

I

n 2 – 250, vorzugsweise 5 bis 50, X = O, S, Se, SO oder $SO_2$ und Y = X oder NH, $CH_2$, CO oder $C_6H_4$.

Das Einarbeiten der Zusätze erfolgt stets unter Ausschluss von Feuchtigkeit (Wasser) sowie Sauerstoff (Luft), es wird daher vorzugsweise unter Argonatmosphäre gearbeitet. Die ggf. verwendeten Lösungsmittel werden nach dem Einarbeiten bei Temperaturen unter 30 °C im Vakuum abgezogen.

Durch die genannten Zusätze können elektrische Leitfähigkeitsanstiege von einigen Grössenordnungen erreicht werden. Die Ausgangsleitfähigkeiten der Polyaromaten betrugen ca. $10^{-13}$S/cm, liefern aber nach der Zugabe der erfindungsgemässen Zusätze Leitfähigkeiten grösser als $10^{-2}$S/cm.

Die erfindungsgemäss hergestellten elektrisch leitfähigen Heteropolyphenylene mit elektrischen Leitfähigkeiten grösser als $10^{-2}$S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säure zum Polyaromaten entstehen sog. n-Leiter, durch die Zusätze der Alkali- oder Erdalkalimetalle oder -amide entstehen sog. p-Leiter.

Die in den Beispielen genannten Teile sind Gewichtsteile, bzw. bei den Zusatzstoffen Molprozent.

Beispiele

10 Teile eines Heteropolyphenylens (I) werden unter Argonatmosphäre und Ausschluss von Feuchtigkeit mit dem jeweiligen Zusatzmittel versetzt, die Messung der elektr. Leitfähigkeit erfolgt nach F. Beck, «Ber. Bunsengesellschaft, Phys. Chem.», 68, 558 bis 567 (1964).

Bei den verwendeten Heteropolyphenylen handelt es sich um den Verbindungstyp (I):

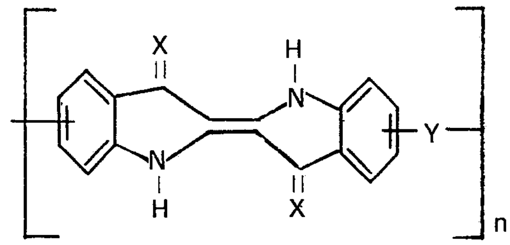

I

(Y= 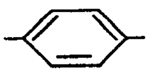 )

| Nr. | Polyaromat Typ und Menge | | Dopingmittel Art und Menge Mol % | Mol % | | Leitfähigkeit S/cm 30 °C vor dem Dopen, nach dem Dopen Gew.-% | | |
|---|---|---|---|---|---|---|---|---|
| 1 | I<br>n = ca. 10<br>x = O | 1 Teil | $AsF_5$ | 0,2 | 20 | 1,2 | $10^{-13}$ | $0{,}5 . 10^{-2}$ |
| 2 | I<br>n = ca. 15<br>x = O | 1 Teil | $SbF_5$ | 0,4 | 40 | 2,0 | do. | $0{,}9 . 10^{-2}$ |
| 3 | I<br>n = ca. 15<br>x = S | 1 Teil | $BF_3$ | 0,5 | 50 | 0,65 | do. | $1{,}5 . 10^{-3}$ |
| 4 | I<br>n = ca. 35<br>x = S | 1 Teil | $NO_2^+SbF_6$ | 0,2 | 20 | 0,5 | $10^{-11}$ | $7{,}0 . 10^{+1}$ |
| 5 | I<br>n = ca. 15<br>x = S | 1 Teil | $NO^+SbF_6$ | 0,2 | 20 | 1,1 | $10^{-12}$, | $2{,}6 . 10^{+1}$ |
| 6 | I<br>n = ca. 20<br>x = Se | 1 Teil | $CF_3SO_3H$ | 0,2 | 20 | 0,3 | do. | $0{,}4 . 10^{+1}$ |
| 7 | I<br>n = ca. 10<br>x = O | 1 Teil | Na | 0,5 | 50 | 0,4 | $10^{-13}$ | $0{,}5 . 10^{-1}$ |
| 8 | I<br>n = ca. 20<br>x = O | 1 Teil | $AsF_5$ | 0,2 | 20 | 0,6 | ca. $10^{-13}$ | $0{,}5 . 10^{-1}$ |
| 9 | I<br>n = ca. 25<br>x = O | 1 Teil | $AsF_5$ | 0,2 | 20 | 0,5 | do. | $1{,}6 . 10^{-2}$ |
| 10 | I<br>n = ca. 35<br>x = O | 1 Teil | $AsF_5$ | 0,2 | 20 | 0,35 | do. | $2{,}3 . 10^{-1}$ |
| 11 | I<br>n = ca. 50<br>x = O | 1 Teil | $AsF_5$ | 0,2 | 20 | 0,25 | do. | $3{,}5 . 10^{+1}$ |
| 12 | I<br>n = ca. 20<br>x = S | 1 Teil | $AsF_5$ | 0,2 | 20 | 0,5 | do. | $4{,}6 . 10^{-1}$ |
| 13 | I<br>n = ca. 80<br>x = S | 1 Teil | $SbF_5$ | 0,2 | 20 | 0,15 | ca. $10^{-12}$ | $9{,}4 . 10^{+1}$ |
| 14 | I<br>n = ca. 35.<br>x = Se | 1 Teil | $AsF_5$ | 0,2 | 20 | 0,2 | ca. $10^{-11}$ | $0{,}6 . 10^{+1}$ |
| 15 | I<br>n = ca. 20<br>x = O | 1 Teil | $H_2SO_4$ | 0,3 | 30 | 0,55 | ca. $10^{-13}$ | $1{,}5 . 10^{-2}$ |

**Patentansprüche:**

1. Verfahren zur Herstellung von elektrisch leitfähigen Heteropolyphenylenen mit elektrischen Leitfähigkeitswerten grösser als $10^{-2}$S/cm, dadurch gekennzeichnet, dass Heteropolyphenylenen der allgemeinen Formel:

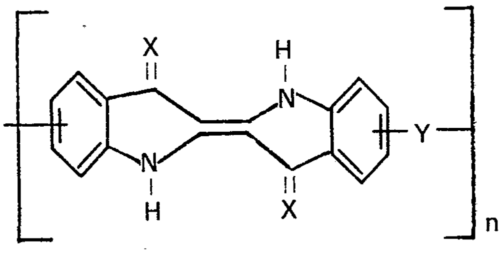

I

in der X gleich O, S, Se, SO oder $SO_2$ und Y gleich X oder NH, $CH_2$, CO oder $C_6H_4$ sein kann und n = 2 bis 250, vorzugsweise 5 bis 50, unter Ausschluss von Wasserfeuchtigkeit und von Sauerstoff 0,5 bis 5 Gewichtsprozent, bezogen auf das eingesetzte Heteropolyphenylen, einer starken Lewis-Säure mit $pK_2$-Werten von 10 bis 14 oder Natrium, Kalium, Rubidium, Cäsium, Calcium oder Barium oder deren Amide als aktivierender Zusatzstoff zugesetzt wird.

2. Verfahren nach Anspruch 1, dadurch gekennzeichnet, dass als Lewis-Säuren die Verbindung $AsF_5$, $SbF_5$, $UF_6$, $HClO_4$, $NO^+SbF_6^-$, $NO_2^+SbF_6^-$, $NO^+AsF_6^-$, $NO^+PF_6^-$, $SbCl_5$, $NO^+BF_4^-$, $(CF_3)_2SO_4$, 2,4,6-Trinitrophenol oder 2,4,6-Trinitrophenylsulfonsäure zugesetzt wird.

3. Verfahren nach Ansprüchen 1 und 2, dadurch gekennzeichnet, dass Na, K, Rb, Cs, Ca oder Ba oder deren Amide in Tetrahydrofuran, Dimethoxyglykol, Anthracen, Naphthalin oder 2-Methylstyrol, jeweils im Molverhältnis 1:1 bis 1:5, vorzugsweise 1:2 bis 1:3, zugesetzt werden.

4. Verwendung der nach Anspruch 1 hergestellten, leitfähigen Heteropolyphenylene in der Elektrotechnik zur Herstellung von Sonnenzellen, zur Umwandlung und Fixierung von Strahlung und zur Herstellung elektrischer und magnetischer Schalter.

5. Verwendung der nach Anspruch 1 hergestellten leitfähigen Heteropolyphenylene zur antistatischen Ausrüstung von Kunststoffen.

**Revendications**

1. Procédé de préparation d'hétéropolyphénylènes conducteurs de l'électricité avec des conductibilités électriques supérieures à $10^{-2}$ s/cm, caractérisé en ce que l'on incorpore à des hétéropolyphénylènes de la formule générale

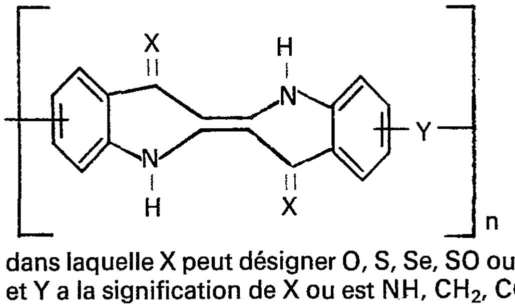

I

dans laquelle X peut désigner O, S, Se, SO ou $SO_2$ et Y a la signification de X ou est NH, $CH_2$, CO ou $C_6H_4$ et n vaut 2 à 250 et de préférence 5 à 50, à l'abri de l'humidité et de l'oxygène 0,5 à 5% du poids de l'hétéropolyphénylène mis en œuvre d'un acide de Lewis fort avec un $pK_a$ de 10 à 14, de sodium, de potassium, de rubidium, de césium, de calcium ou de baryum, ou d'un amide de ceux-ci, en tant qu'additif activant.

2. Procédé suivant la revendication 1, caractérisé en ce que l'on choisit l'acide de Lewis parmi les composés $AsF_5$, $SbF_5$, $HClO_4$, $NO^+SbF_6^-$, $NO_2^+SbF_6^-$, $NO^+AsF_6^-$, $NO^+PF_6^-$, $SbCl_5$, $NO^+BF_4^-$, et $(CF_3)_2SO_4$, le trinitro-2,4,6 phénol et l'acide trinitro-2,4,6 phényl sulfonique.

3. Procédé suivant les revendications 1 et 2, caractérisé en ce que l'on ajoute du Na, du K, du Rb, du Cs, du Ca ou du Ba ou leurs amides dans du tétrahydrofuranne, du diméthoxy-glycol, de l'anthracène, du naphtalène ou du méthyl-2-styrène, chaque fois dans un rapport molaire de 1:1 à 1:5 et de préférence de 1:2 à 1:3.

4. Utilisation des hétéropolyphénylènes conducteurs de l'électricité, préparés par le procédé de la revendication 1, dans l'électro-technique pour la fabrication de cellules solaires, pour la transformation et la fixation de radiations et pour la fabrication de commutateurs électriques et magnétiques.

5. Utilisation des hétéropolyphénylènes conducteurs de l'électricité, préparés par le procédé de la revendication 1, pour l'apprêtage antistatique de matières plastiques.

**Claims**

1. A process for the production of an electrically conductive heteropolyphenylene having a conductivity greater than $10^{-2}$ S/cm, wherein from 0,5 to 5 per cent by weight, based on the heteropolyphenylene employed, of a strong Lewis acid having a $pK_a$ from 10 to 14, or sodium, potassium rubidium, cesium calcium or barium or an amide thereof, as activating additive, is added, in the absence of moisture and of oxygen, to a heteropolyphenylene of the general formula

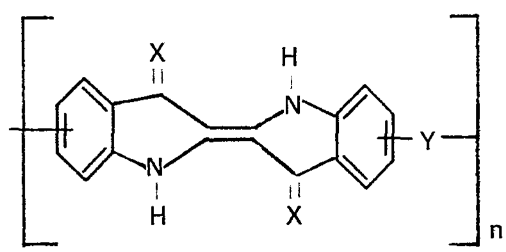

I

where X is O, S, Se, SO or $SO_2$, Y has the same meanings as X or is NH, $CH_2$, CO or $C_6H_4$ and n is from 2 to 250, preferably from 5 to 50.

2. A process as claimed in claim 1, wherein the Lewis acid used is $AsF_5$, $SbF_5$, $UF_6$, $HClO_4$, $NO^+SbF_6^-$, $NO_2$ $^+SbF_6^-$, $NO^+AsF_6^-$, $NO^+$ $PF_6^-$, $SbCl_5$, $NO^+BF_4^-$ $(CF_3)_2SO_4$, 2,4, 6-trinitrophenol or 2,4,6-trinitrophenylsulfonic acid.

3. A process as claimed in claims 1 and 2, wherein Na, K, Rb, Cs, Ca or Ba or an amide thereof is added in tetrahydrofuran, dimethoxyglycol, anthracene, naphthalene or 2-methylstyrene, in

each case in a molar ratio of the former component to the latter component of from 1:1 to 1:5, preferably from 1:2 to 1:3.

4. The use of a conductive heteropolyphenylene, produced as claimed in claim 1, in electrical engineering for the production of solar cells, for the conversion and fixation of radiation, and for the production of electrical and mechanical switches.

5. The use of a conductive heteropolyphenylene, produced as claimed in claim 1, for the antistatic finishing of plastics.